**Europäisches Patentamt**

**European Patent Office**

**Office européen des brevets**

(19)

(11) Veröffentlichungsnummer: **0 107 153 B1**

(12) **EUROPÄISCHE PATENTSCHRIFT**

(45) Veröffentlichungstag der Patentschrift:
28.01.87

(51) Int. Cl.⁴: **H 01 R 19/40**

(21) Anmeldenummer: **83110201.7**

(22) Anmeldetag: **13.10.83**

(54) Anschlussdose für den Anschluss eines Fernsprechapparates und/oder eines oder mehrerer Fernsprech-Zusatzgeräte.

(30) Priorität: **22.10.82 DE 3239063**

(43) Veröffentlichungstag der Anmeldung:
**02.05.84 Patentblatt 84/18**

(45) Bekanntmachung des Hinweises auf die Patenterteilung:
**28.01.87 Patentblatt 87/5**

(84) Benannte Vertragsstaaten:
**AT BE CH DE FR GB IT LI LU NL SE**

(56) Entgegenhaltungen:
**DE - A - 1 590 091**
**DE - A - 3 002 563**
**DE - A - 3 036 136**
**US - A - 1 938 309**
**US - A - 2 828 394**
**US - A - 3 331 991**

(73) Patentinhaber: **Quante Fernmeldetechnik GmbH, Uellendahler Str. 353, D-5600 Wuppertal 1 (DE)**

(72) Erfinder: **Quante, Hermann, Uellendahler Strasse 353, D-5600 Wuppertal 1 (DE)**

(74) Vertreter: **Mentzel, Norbert, Dipl.-Phys. et al, Patentanwälte Dipl.-Phys. Buse Dipl.-Phys. Mentzel Dipl.-Ing. Ludewig Unterdörnen 114, D-5600 Wuppertal 2 (DE)**

## Beschreibung

Die Erfindung betrifft eine Anschlussdose für den Anschluss eines Fernsprechapparates und/oder eines oder mehrerer Fernsprech-Zusatzgeräte, wie Rufnummerngeber, Lauthörgerät, Anrufbeantworter, Fernkopierer, Modemgerät od. dgl., bestehend aus einem eine Abdeckung tragenden gehäuseförmigen Grundteil, das einerseits feste Anschlussklemmen wie Schraubklemmen oder abisolierfreie, elektrische Anschlussklemmen für die Fernmeldezuleitung und andererseits mindestens eine über eine Leiterplatte mit den Anschlussklemmen verbundene Steckeraufnahme für den zugehörigen Stecker des Fernsprechapparates und/oder der Fernsprech-Zusatzgeräte aufweist, wobei für mindestens mehrere Anwendungsfälle eine einheitliches Anschlussmuster mit Aufnahmebohrungen vorhanden ist.

Bei dieser aus der DE-A 3 036 136 bekannten Anschlussdose weist das gehäuseförmige Grundteil eine mit Verbindungskontakten ausgerüstete Aufnahme für einen austauschbar darin einsetzbaren, ausgewählten Dosenwandler auf, der mit den Verbindungskontakten des Grundteiles kuppelbare Gegenkontakte trägt und ein dem jeweiligen Anschlusszweck spezifisch angepasstes Kupplungsprofil mit Anschlusskontakten für die Steckkupplungen von wahlweise anschliessbaren Fernsprechapparaten und/oder Zusatzgeräten aufweist. Obwohl man eine Anschlussdose einheitlicher Bautype verwendet, ist es möglich, sie jedem Verwendungszweck individuell anzupassen, ohne dass umständliche Montagearbeiten erforderlich sind. Dieser Vorteil ergibt sich nicht nur in der Anfangsmontage einer Anschlussdose, wo sie bereits insoweit eine Vereinfachung bringt, als für alle Zwecke das gleiche Grundteil verwendet wird, sondern auch nach dem Anschluss einer Anschlussdose, weil diese jedem neuen Benutzungsfall angepasst werden kann. Der neue Anwendungsfall kann darin bestehen, dass an der Anschlussdose der Wunsch nach einer Verdoppelung oder Vervielfachung der Anschlussmöglichkeiten für einen Fernsprechapparat und ein Fernsprech-Zusatzgerät auftaucht oder dass die Art des Gerätes verändert werden soll, beispielsweise wenn man anstelle eines Anrufbeantworters einen Fernkopierer verwenden will.

Entsprechend dem jeweiligen Anwendungsfall ist somit in das gehäuseförmige Grundteil der entsprechende Dosenwandler einzusetzen. Der Dosenwandler besteht dabei aus einem Gehäuse, in dem eine Leiterplatte eingesetzt ist. Die Leiterplatte ist dabei einerseits mit den Gegenkontakten versehen, mit denen die elektrisch leitende Kupplung mit den Verbindungskontakten des gehäuseförmigen Grundteiles herstellbar ist. Weiterhin sind an der Leiterplatte mindestens ein dem jeweiligen Anschlusszweck spezifisch angepasstes Kupplungsprofil mit Anschlusskontakten für die Steckkupplungen von wahlweise anschliessbaren Fernsprechapparaten und/oder Zusatzgeräten vorgesehen. Für die unterschiedlichen Anwendungsfälle müssen somit entsprechende Dosenwandler auf Lager gehalten werden. Die Dosenwandler bestehen dabei jedoch aus einer Vielzahl von Einzelteilen, die zusammen mit den Montagekosten für den Zusammenbau eine kostenaufwendige Lagerhaltung ergibt.

Der Erfindung liegt die Aufgabe zugrunde, eine Anschlussdose der eingangs erläuterten Art zu schaffen, bei der der Kostenaufwand für die Lagerhaltung der für die unterschiedlichen Anwendungsfälle austauschbaren Teile möglichst gering gehalten wird, indem möglichst viele Teile der Anschlussdose für die Benutzung für alle Anwendungsfälle ausgebildet werden und für die Umrüstung bzw. Nachrüstung möglichst nur einzelne Teile erforderlich sind.

Diese Aufgabe ist erfindungsgemäss dadurch gelöst, dass die Leiterplatte die festen Anschlussklemmen trägt und das einheitliche Anschlussmuster mit den Aufnahmebohrungen für die je nach Bedarf einzusetzenden, von Stecksockeln gebildeten Steckaufnahmen aufweist, wobei die austauschbaren und/oder nachrüstbaren Stecksockel zu deren Befestigung auf der Leiterplatte lediglich mit von deren Kontakten ausgehenden Lötanschlüssen in die Aufnahmebohrungen einsetzbar und verlötbar sind.

Die Leiterplatte trägt somit die festen Anschlussklemmen und weist für mindestens mehrere Anwendungsfälle ein einheitliches Anschlussmuster mit Aufnahmebohrungen für die je nach Bedarf einzusetzenden, von Stecksockeln gebildeten Steckeraufnahmen auf. Für die meisten Anwendungsfälle sind somit lediglich an der Leiterplatte die von Stecksockeln gebildeten Steckeraufnahmen an einer anderen Stelle anzuordnen bzw. zusätzliche Stecksockel anzubringen. Die für die unterschiedlichen Anwendungsfälle benutzten Stecksockel können dabei gleich ausgebildet sein, da das spezifisch angepasste Kupplungsprofil der Stecker mit entsprechend ausgebildeten, maskenartigen Durchbrüchen des gehäuseförmigen Grundteiles zusammenwirken kann. Für diese unterschiedlichen Anwendungsfälle sind somit lediglich diese von Stecksockeln gebildeten Steckeraufnahmen auf Lager zu halten. Da die von Stecksockeln gebildeten Steckeraufnahmen auf der Leiterplatte eingelötet werden, wird zugleich in der Anschlussdose ein zusätzliches Kontaktpaar vermieden, welches durch seine Übergangswiderstände die elektrischen Eigenschaften der Übertragungsstrecke ungünstig beeinflussen könnte.

Die Leiterplatte kann in dem aus einem Gehäuseunterteil und einem daran befestigbaren Gehäuseoberteil bestehenden Grundteil eingesetzt und gehaltert sein. Durch dieses Einsetzen der Leiterplatte in dem gehäuseförmigen Grundteil ist die Leiterplatte in einfacher Weise gegen Verschmutzung und Beschädigung gesichert.

Die festen Anschlussklemmen können mit einer Leiste an der Leiterplatte gehalten sein und durch einen Durchbruch aus dem Gehäuseoberteil des gehäuseförmigen Grundteiles herausragen und von dem plattenförmigen Gehäuseunterteil unterstützt sein. Die festen Anschlussklemmen sind somit in einfacher Weise für den Anschluss der Leitungen frei zugänglich, da die die Anschlussklemmen tragende Leiste aus einem Durchbruch des Gehäuseoberteiles herausragt. Mit dem plattenförmigen Gehäuseunterteil wird die Leiterplatte insbesondere auch in dem Bereich unterstützt, an dem die Anschlussklemmen vorgesehen sind, so dass der bei der Montage auf die Anschlussklemmen ausgeübte Druck keinerlei Beschädigungen der Leiterplatte hervorrufen kann.

Das Gehäuseoberteil kann mit einer Reihe von der Innenseite ausgehender schachtförmiger Aufnahmen für die formschlüssige Aufnahme der von Stecksockeln gebildeten und einen etwa U-förmigen Querschnitt aufweisenden Steckeraufnahmen versehen sein. Dadurch sind in einfacher Weise die von Stecksockeln gebildeten und einen etwa U-förmigen Querschnitt aufweisenden Steckeraufnahmen in den schachtförmigen Aufnahmen formschlüssig aufgenommen, so dass beim Einstecken der zugehörigen Stecker die einen etwa U-förmigen Querschnitt aufweisenden Steckeraufnahmen nicht in unzulässiger Weise aufgespreizt werden, wodurch ein Zerbrechen bzw. eine schlechte Kontaktgabe hervorgerufen werden könnte.

Die im Gehäuseoberteil vorgesehenen, von der Innenseite ausgehenden schachtförmigen Aufnahmen für die formschlüssige Aufnahme der von Stecksockeln gebildeten Steckeraufnahmen können Böden mit dem jeweiligen Steckerprofil entsprechenden Durchbrüchen aufweisen. Die Durchbrüche in den Böden der schachtförmigen Aufnahmen sind somit ein einfacher Weise dem jeweiligen Steckerprofil angepasst und gewährleisten somit in einfacher Weise, dass jeder Stecker jeweils nur in die zugehörige Steckeraufnahme eingesteckt werden kann.

Die dem jeweiligen Steckerprofil entsprechenden Durchbrüche in den Böden der Aufnahmen für die Stecksockel können mit heraustrennbaren Wandteilen verschlossen sein. Das gehäuseförmige Grundteil mit seinem Gehäuseoberteil und seinem Gehäuseunterteil ist somit für alle Anwendungsfälle verwendbar, da je nach Anwendungsfall die heraustrennbaren Wandteile entfernt werden.

Die am gehäuseförmigen Grundteil befestigbare Abdeckung kann formschlüssig die Stecker aufnehmende Führungsschächte aufweisen, die von einer zum gehäuseförmigen Grundteil gerichteten, rohrförmigen Anformung gebildet ist und in der der die schachtförmigen Aufnahmen für die Stecksockel bildende Ansatz des Gehäuseoberteiles mit einem Teilbereich eingreift. Mit dieser Abdeckung, die kappenförmig für die Aufputzmontage und plattenförmig für die Unterputzmontage ausgebildet sein kann, wird eine schmutz- und beschädigungssichere Abdeckung des gehäuseförmigen Grundteiles erzielt, wobei mit den formschlüssig die Stecker aufnehmenden Führungsschächten der Abdeckung dabei zugleich eine gegen Wackeln gesicherte Aufnahme der Stecker erzielt wird, wodurch eine elektrisch optimale Verbindung zwischen Stecker und Verbinderdose gesichert ist.

Der die schachtförmigen Aufnahmen für die Stecksockel bildende Ansatz des Gehäuseoberteiles kann bedarfsweise abnehmbare Verlängerungen aufweisen, die in seitliche Aussparungen der Führungsschächte der Abdeckung eingreifen und jeweils eine Rastausnehmung für an den Steckern vorgesehene Rastvorsprünge aufweisen. Die Verrastung des Steckers erfolgt somit unmittelbar an Teilen des Gehäuseoberteiles, der die mit dem jeweiligen Stecker zusammenwirkende Steckeraufnahme haltert, so dass die Verrastung unabhängig von wandbedingten Schrägstellungen der Abdeckung ist.

Das gehäuseförmige Grundteil kann vorzugsweise an der den Anschlussklemmen abgekehrten Seite einen Randbereich zur Halterung von zusätzlichen Bauelementen wie Leitungsabschlüsse, Leitungsdämpfungen od. dgl. aufweisen. An dem gehäuseförmigen Grundteil ist somit ein Freiraum für die bedarfsweise Anbringung von zusätzlichen Bauelementen wie Leitungsabschlüssen, Leitungsdämpfungen od. dgl. vorgesehen.

Das Gehäuseoberteil kann einen Durchbruch zum Durchführen der von zusätzlichen Bauelementen kommenden Verbindungsleitungen zu der im gehäuseförmigen Grundteil angeordneten Leiterplatte aufweisen.

Auf der Zeichnung ist die Erfindung in einem Ausführungsbeispiel im vergrösserten Massstab dargestellt, und zwar zeigen:

Fig. 1 die erfindungsgemässe Anschlussdose mit drei Steckern in Draufsicht,

Fig. 2 einen Schnitt nach der Linie II–II der Fig. 1,

Fig. 3 die Anschlussdose in Draufsicht bei abgenommener Abdeckung mit drei Steckeraufnahmen,

Fig. 4 eine der Fig. 3 entsprechende Darstellung mit zwei Steckeraufnahmen,

Fig. 5 eine den Fig. 3 und 4 entsprechende Darstellung mit einer Steckeraufnahme,

Fig. 6 die in der Anschlussdose benutzbare Leiterplatte in Draufsicht,

Fig. 7 vom gehäuseförmigen Grundteil der Anschlussdose das Oberteil in Unteransicht,

Fig. 8 einen Schnitt nach der Linie VIII–VIII der Fig. 7,

Fig. 9 von dem gehäuseförmigen Grundteil das Unterteil in Draufsicht und

Fig. 10 einen Schnitt nach der Linie X–X der Fig. 9.

Die in den Zeichnungen dargestellte Anschlussdose ist für den Anschluss eines Fernsprechapparates und/oder eines oder mehrerer Fernsprech-Zusatzgeräte wie Rufnummerngeber, Lauthörgerät, Anrufbeantworter, Fernkopierer, Modemgerät od. dgl. vorgesehen. Der Fernsprechapparat und die Fernsprech-Zusatzgeräte sind dabei der Einfachheit halber nicht näher dargestellt, sondern nur deren Stecker 20, 21 und 22, mit denen der Anschluss an der Anschlussdose erfolgt.

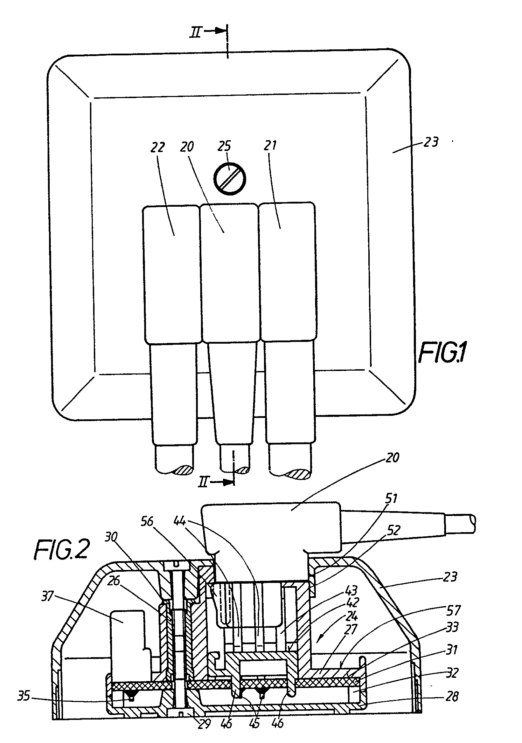

Die Anschlussdose (Fig. 2) besteht aus einem eine Abdeckung 23 tragenden gehäuseförmigen Grundteil 24. Beim dargestellten Ausführungsbeispiel ist die Abdeckung 23 von einer Abdeckkappe gebildet, so dass die Anschlussdose für die Aufputzmontage vorgesehen ist. Die Abdeckung kann auch plattenförmig ausgebildet sein, um die Montage in einer Unterputzdose zu ermöglichen. Die Befestigung der Abdeckung 23 erfolgt mit einer Schraube 25 in einem Gewindeeinsatz 26 des gehäuseförmigen Grundteiles 24.

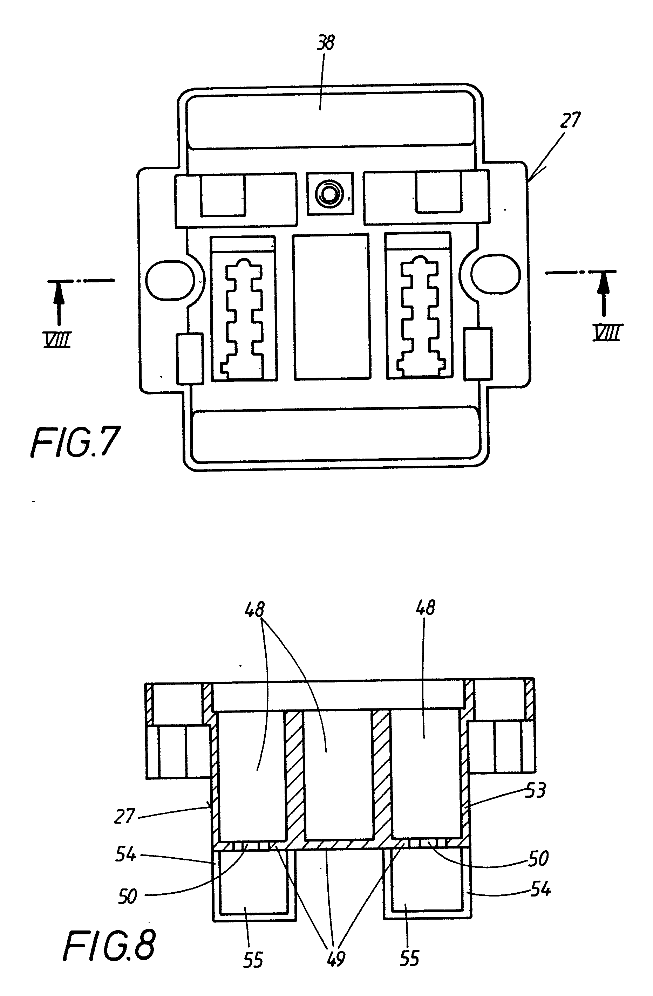

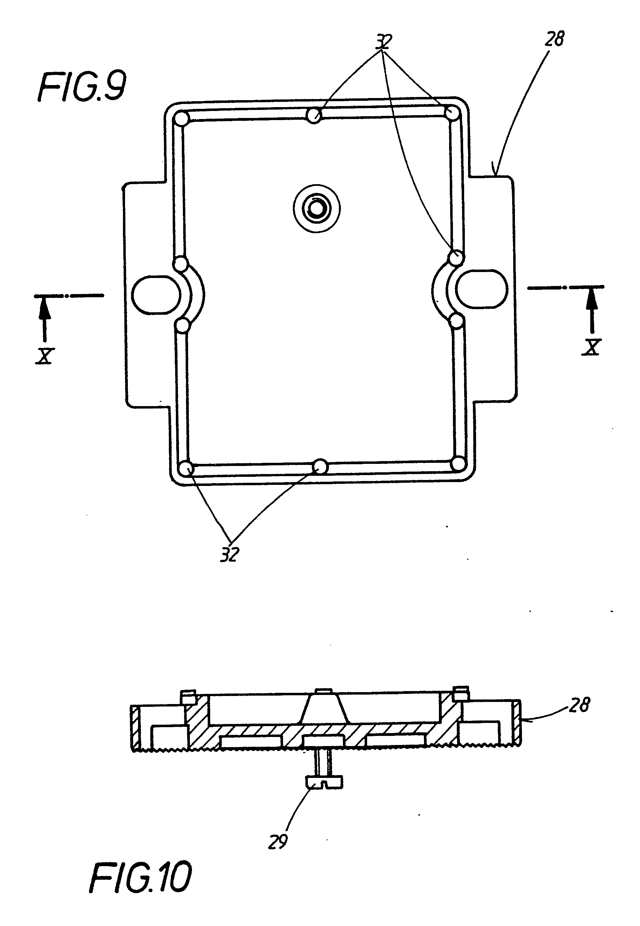

Das gehäuseförmige Grundteil 24 besteht aus einem Gehäuseoberteil 27, welches in den Fig. 7 und 8 näher dargestellt ist, und einem Gehäuseunterteil 28, welches in den Fig. 9 und 10 näher dargestellt ist. Die Befestigung des Gehäuseunterteiles 28 an dem Gehäuseoberteil 27 erfolgt dabei mit einer Schraube 29, die in das untere freie Ende des Gewindeeinsatzes 26 einziehbar ist. Der Gewindeeinsatz 26 ist dabei, wie insbesondere aus der Fig. 2 ersichtlich, in einem Durchbruch des Gehäuseoberteiles 27 eingesetzt und mit einer Umbördelung 30 gehalten.

Aus der Fig. 2 ist weiterhin ersichtlich, dass zwischen dem Gehäuseoberteil 27 und dem Gehäuseunterteil 28 eine Leiterplatte 31 eingespannt ist. Der Gehäuseunterteil 28 weist dabei angeformte Andrückzapfen 32 auf, mit denen die Leiterplatte 31 gegen die Anlagefläche 33 des Gehäuseoberteiles 27 angedrückt wird. Die Leiterplatte 31 ist somit gegen Staub geschützt im gehäuseförmigen Grundteil 24 angeordnet und durch die Andrückung gegen die Anlagefläche 33 des Gehäuseoberteiles 27 gegen Verbiegungen od. dgl geschützt, wodurch die gedruckten Leitungen beschädigt werden könnten.

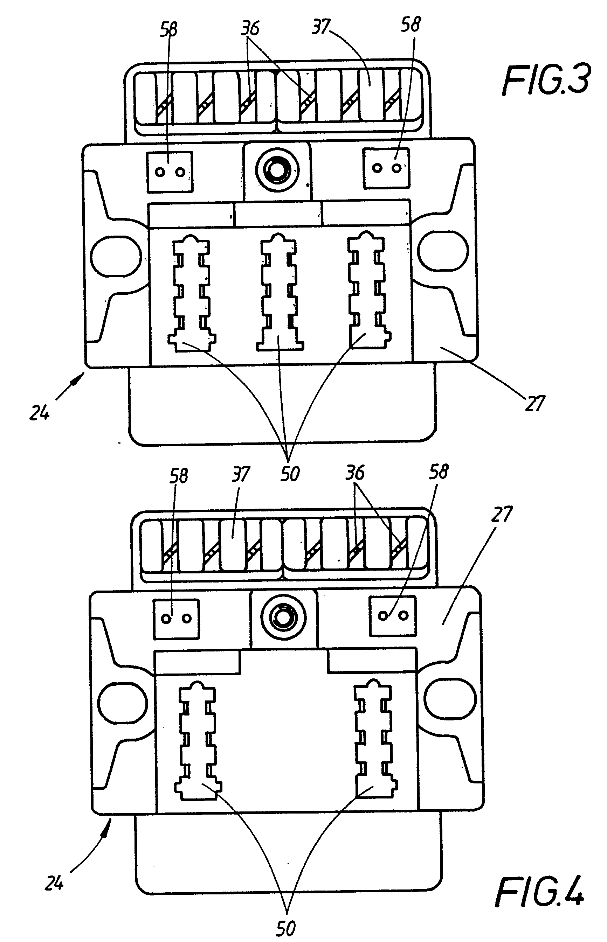

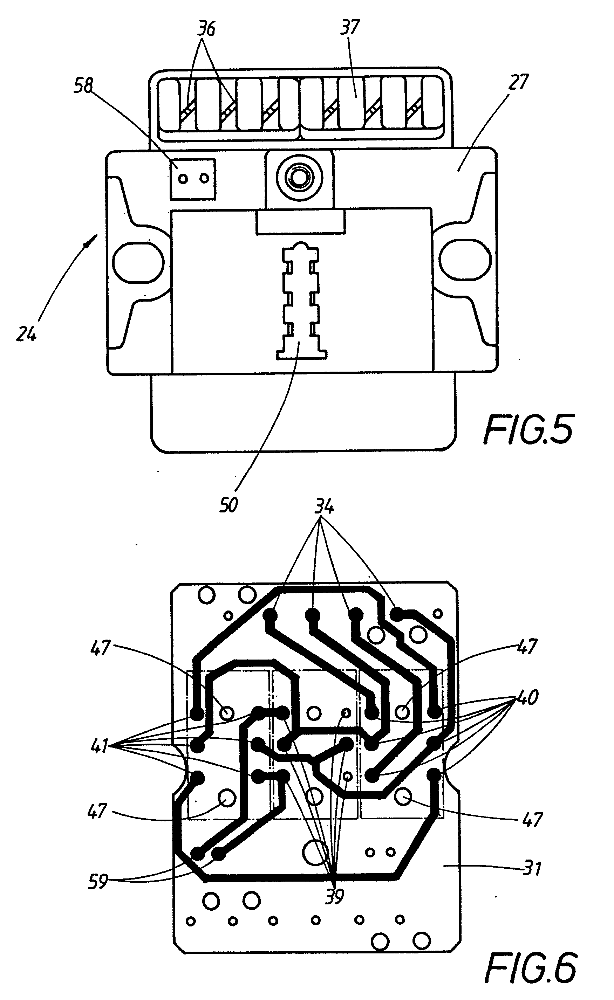

Die Leiterplatte 31 ist in der Fig. 6 näher dargestellt. In der Leiterplatte sind dabei 6 Aufnahmebohrungen 34 vorgesehen, die von den Lötanschlüssen 35 fester Anschlussklemmen durchgriffen sind. Die Lötanschlüsse 35 sind dabei in den Aufnahmebohrungen 34 der Leiterplatte 31 eingelötet. Beim dargestellten Ausführungsbeispiel sind die Anschlussklemmen von abisolierfreien, elektrischen Anschlussklemmen 36 gebildet, wie es insbesondere aus den Fig. 3 bis 5 ersichtlich ist. Die abisolierfreien, elektrischen Anschlussklemmen 36 sind dabei in einer Leiste 37 angeordnet, die durch Kleben od. dgl. an der Leiterplatte 31 befestigt ist. Wie insbesondere aus der Fig. 2 ersichtlich, ragt die Leiste 37 mit abisolierfreien, elektrischen Anschlussklemmen 36 durch einen Durchbruch 38 aus dem Gehäuseoberteil 27 des gehäuseförmigen Grundteiles 24 heraus und wird von dem plattenförmigen Gehäuseunterteil 28 unterstützt, so dass beim Eindrücken der nicht näher dargestellten Leitungen in die abisolierfreien, elektrischen Anschlussklemmen 36 ein Beschädigen der Leiterplatte 31 nicht zu befürchten ist.

Die Leiterplatte 31 weist, wie insbesondere aus der Fig. 6 ersichtlich, für mindestens mehrere Anwendungsfälle ein einheitliches Anschlussmuster mit Aufnahmebohrungen 39, 40, 41 für die je nach Bedarf einzusetzenden, von Stecksockeln 42 gebildeten Steckeraufnahmen 43 auf. Die austauschbaren und/oder nachrüstbaren Stecksockel 42 sind zu deren Befestigung auf der Leiterplatte 31 lediglich mit von deren Kontakten 44 ausgehenden Lötanschlüsse 45 in die Aufnahmebohrungen 39, 40 bzw. 41 einsetzbar und verlötbar. Der die Steckeraufnahme 43 bildende Stecksockel 42 ist dabei aus Kunststoff gebildet und weist, wie insbesondere aus der Fig. 2 ersichtlich, zwei nach unten gerichtete Einsteckzapfen 46 auf, die in entsprechende Bohrungen 47 der Leiterplatte 31 eingreifen. Dadurch sind die die Steckeraufnahmen 43 bildenden Stecksockel 42 zuverlässig auf der Leiterplatte 31 gehaltert und können somit auch vom Monteur an der Montagestelle mit den entsprechenden Stecksockeln ausgerüstet oder umgerüstet werden.

Das Gehäuseoberteil 27 weist, wie insbesondere aus den Fig. 7 und 8 ersichtlich, drei in einer Reihe liegende, von der Innenseite ausgehender schachtförmiger Aufnahmen für die formschlüssige Aufnahme der von Stecksockeln 42 gebildeten und einen etwa U-förmigen Querschnitt aufweisenden Steckeraufnahmen 43 auf. Beim Einstecken des zugehörigen Steckers 20, 21 bzw. 22 wird die Steckeraufnahme 43 im Sinne eines Aufspreizens belastet. Dieses Aufspreizen der etwa U-förmigen Steckeraufnahme 43 wird jedoch in einfacher Weise durch die formschlüssige Aufnahme des die Steckeraufnahme 43 bildenden Stecksockels 42 in der jeweils zugehörigen schachtförmigen Aufnahme 48 des Gehäuseoberteiles 27 verhindert. Die im Gehäuseoberteil 27 vorgesehenen, von der Innenseite ausgehenden schachtförmigen Aufnahmen 48 für die formschlüssige Aufnahme der von Stecksockeln 42 gebildeten Steckeraufnahmen 43 weisen Böden 49 mit dem jeweiligen Steckerprofil entsprechenden Durchbrüchen 50 auf. Die dem jeweiligen Steckerprofil entsprechenden Durchbrüche 50 in den Böden 49 der Aufnahmen 48 für die Stecksockel 42 sind mit heraustrennbaren Wandteilen verschlossen. Je nach Bedarf können somit diese Wandteile entfernt werden, so dass die Durchbrüche 50 in den Böden 49 der schachtförmigen Aufnahmen 48 entstehen. In der Fig. 3 sind dabei drei Durchbrüche 50 eingezeichnet, während in der Fig. 4 zwei Durchbrüche 50 und in der Fig. 5 lediglich ein Durchbruch 50 dargestellt ist. Die erfindungsgemässe Anschlussdose ist somit in einfacher Weise allen auftretenden Anwendungen anpassbar.

Die am gehäuseförmigen Grundteil 24 befestigbare Abdeckung 23 weist formschlüssig die die Stecker 20, 21, 22 aufnehmenden Führungsschächte 51 auf, die von einer zum gehäuseförmigen Grundteil 24 gerichteten rohrförmigen Anformung 52 gebildet sind. In diese rohrförmige Anformung 52 der Abdeckung 23 greift der die schachtförmigen Aufnahmen 48 für die Stecksockel 42 bildende Ansatz 53 des Gehäuseoberteiles 27 mit einem Teilbereich ein. Durch dieses Aufsetzen der rohrförmigen Anformung 52 der Abdeckung 23 auf den die schachtförmigen Aufnahmen 48 für die Stecksockel 42 bildenden Ansatz 53 des Gehäuseoberteiles 27 wird eine lagegenaue Aufsetzung der Abdeckung 23 auf das gehäuseförmige Grundteil 25 gewährleistet.

Der die schachtförmigen Aufnahmen 48 für die Stecksockel 42 bildende Ansatz 53 des Gehäuseoberteiles 27 weist Verlängerungen 54 auf, die in seitliche Aussparungen der Führungsschächte 51 der Abdeckung 23 eingreifen. Die Stecker 20, 21, 22 sind somit zur Verbindung an der Anschlussdose verrastet. Die Verrastung der Stecker 20, 21, 22 erfolgt dabei nicht an der Abdeckung 23, sondern an dem gehäuseförmigen Grundteil 24. Schrägstellungen der Abdeckung entsprechend der Wand, an der die Anschlussdose befestigt wird, haben somit keinen Einfluss auf die Verbindung der Stecker 20, 21, 22 mit dem gehäuseförmigen Grundteil 24 der Anschlussdose.

Beim dargestellten Ausführungsbeispiel ist an dem Ansatz 53 des Gehäuseoberteiles 27 für jeden Stecker 20, 21 oder 22 jeweils nur eine Verlängerung 54 vorgesehen. Bedarfsweise können jedoch an beiden Enden des Steckers solche Verlängerungen zur Verrastung vorgesehen werden.

Der gehäuseförmige Grundteil 24 kann vorzugsweise an der den Anschlussklemmen 36 abgekehrten Seite einen Randbereich 57 zur Halterung von zusätzlichen Bauelementen wie Leitungsabschlüsse, Leitungsdämpfungen od. dgl. aufweisen, die der Einfachheit halber nicht näher dargestellt sind. Das Gehäuseoberteil 27 weist je nach Bedarf Durchbrüche 58 zum Durchführen von zusätzlichen Bauelementen kommenden Verbindungsleitung zu der im gehäuseförmigen Grundteil 24 angeordneten Leiterplatte 31 auf. Die Leiterplatte 31 ist für die Verbindung mit Aufnahmebohrungen für Steckkontakte 59 versehen.

Bezugszeichenliste:

20 Stecker mitte
21 Stecker rechts
22 Stecker links
23 Abdeckung
24 gehäuseförmiges Grundteil
25 Schraube
26 Gewindeeinsatz
27 Gehäuseoberteil
28 Gehäuseunterteil
29 Schraube
30 Umbördelung an 26
31 Leiterplatte
32 Andrückzapfen
33 Anlagefläche von 27
34 Aufnahmebohrungen
35 Lötanschluss
36 abisolierfreie, elektrische Anschlussklemmen
37 Leiste
38 Durchbruch für 37 in 27
39 Aufnahmebohrungen
40 Aufnahmebohrungen rechts
41 Aufnahmebohrungen links
42 Stecksockel
43 Steckeraufnahme
44 Kontakte von 43
45 Lötanschluss
46 Einsteckzapfen
47 Bohrungen
48 schachtförmige Aufnahme
49 Böden von 48
50 Durchbrüche
51 Führungsschächte
52 rohrförmige Anformung
53 Ansatz an 27
54 Verlängerungen
55 Rastausnehmung
56 Rastvorsprünge
57 Randbereich
58 Durchbruch
59 Aufnahmebohrungen für Steckkontakte

**Patentansprüche**

1. Anschlussdose für den Anschluss eines Fernsprechapparates und/oder eines oder mehrerer Fernsprech-Zusatzgeräte, wie Rufnummerngeber, Lauthörgerät, Anrufbeantworter, Fernkopierer, Modemgerät od. dgl., bestehend aus einem eine Abdeckung (23) tragenden gehäuseförmigen Grundteil (24), das einerseits feste Anschlussklemmen (36), wie Schraubklemmen oder abisolierfreie, elektrische Anschlussklemmen, für die Fernmeldezuleitung und andererseits mindestens eine über eine Leiterplatte (31) mit den Anschlussklemmen (36) verbundene Steckeraufnahme (43) für den zugehörigen Stecker des Fernsprechapparates und/oder der Fernsprech-Zusatzgeräte aufweist, wobei für mindestens mehrere Anwendungsfälle ein einheitliches Anschlussmuster mit Aufnahmebohrungen (39, 40, 41) vorhanden ist, dadurch gekennzeichnet, dass die Leiterplatte (31) die festen Anschlussklemmen (36) trägt und das einheitliche Anschlussmuster mit den Aufnahmebohrungen (39, 40, 41) für die je nach Bedarf einzusetzenden, von Stecksockeln (42) gebildeten Steckeraufnahmen (43) aufweist, wobei die austauschbaren und/oder nachrüstbaren Stecksockel (42) zu deren Befestigung auf der Leiterplatte (31) lediglich mit von deren Kontakten (44) ausgehenden Lötanschlüssen (45) in die Aufnahmebohrungen (39, 40, 41) einsetzbar und verlötbar sind.

2. Anschlussdose nach Anspruch 1, dadurch gekennzeichnet, dass die Leiterplatte (31) in dem aus einem Gehäuseunterteil (28) und einem daran befestigbaren Gehäuseoberteil (27) bestehenden Grundteil (24) eingesetzt und gehaltert ist.

3. Anschlussdose nach Anspruch 1 oder 2, dadurch gekennzeichnet, dass die festen Anschlussklemmen (36) mit einer Leiste (37) an der Leiterplatte (31) gehalten sind und durch einen Durchbruch (38) aus dem Gehäuseoberteil (27) des gehäuseförmigen Grundteiles (24) herausragen und von dem plattenförmigen Gehäuseunterteil (28) unterstützt sind.

4. Anschlussdose nach einem der Ansprüche 1 bis 3, dadurch gekennzeichnet, dass das Gehäuseoberteil (27) mit einer Reihe, von der Innenseite ausgehender schachtförmiger Aufnahmen (48) für die formschlüssige Aufnahme der von Stecksockeln (42) gebildeten und einen etwa U-förmigen Querschnitt aufweisenden Steckeraufnahmen (42) versehen ist.

5. Anschlussdose nach einem der Ansprüche 1 bis 4, dadurch gekennzeichnet, dass die im Gehäuseoberteil (27) vorgesehen, von der Innenseite ausgehenden schachtförmigen Aufnahmen (48) für die formschlüssige Aufnahme der von Stecksockeln (42) gebildeten Steckeraufnahmen (43) Böden (49) mit dem jeweiligen Steckerprofil entsprechenden Durchbrüchen (50) aufweisen.

6. Anschlussdose nach Anspruch 5, dadurch gekennzeichnet, dass die dem jeweiligen Steckerprofil entsprechenden Durchbrüche (50) in den Böden (49) der Aufnahmen (48) für die Stecksockel (42) mit heraustrennbaren Wandteilen verschlossen sind.

7. Anschlussdose nach einem der Ansprüche 1 bis 6, dadurch gekennzeichnet, dass die am gehäuseförmigen Grundteil (24) befestigbare Abdeckung (23) formschlüssig die Stecker (20, 21, 22) aufnehmende Führungsschächte (51) aufweist, die von einer zum gehäuseförmigen Grundteil (24) gerichteten rohrförmigen Anformung (52) gebildet ist und in der der die schachtförmigen Aufnahmen (48) für die Stecksockel (42) bildende Ansatz (53) des Gehäuseoberteiles (27) mit einem Teilbereich eingreift.

8. Anschlussdose nach einem der Ansprüche 1 bis 7, dadurch gekennzeichnet, dass der die schachtförmigen Aufnahmen (48) für die Stecksockel (42) bildende Ansatz (53) des Gehäuseoberteiles (27) Verlängerungen (54) aufweist, die in seitliche Aussparungen der Führungsschächte (51) der Abdeckung (23) eingreifen, und jeweils eine Rastausnehmung (55) für an den Steckern (20, 21, 22) vorgesehene Rastvorsprünge (56) aufweisen.

9. Anschlussdose nach einem der Ansprüche 1 bis 8, dadurch gekennzeichnet, dass das gehäuseförmige Grundteil (24) vorzugsweise an der den Anschlussklemmen (36) abgekehrten Seite einen Randbereich (57) zur Halterung von zusätzlichen Bauelementen wie Leitungsabschlüsse, Leitungsdämpfungen od. dgl. aufweist.

10. Anschlussdose nach Anspruch 9, dadurch gekennzeichnet, dass das Gehäuseoberteil (27) einen Durchbruch (58) zum Durchführen der von zusätzlichen Bauelementen kommenden Verbindungsleitungen zu der im gehäuseförmigen Grundteil (24) angeordneten Leiterplatte (31) aufweist.

**Claims**

1. A connecting box for the connection of a telephone apparatus and/or one or more additional sets, e.g., an automatic dialler, speakerphone, telephone answering set, remote copier, modem set, or similar, said connecting box consisting of a housing-shaped base unit (24) carrying a cover (23) and equipped on one side with fixed terminals (36) for the incoming telecommunication line, e.g., screw terminals or connecting terminals which require no stripping of insulation, the other side being equipped with a minimum of one plus receptacle (43) connected to the terminals (36) via a printed circuit board (31), said receptacle serving to receive the corresponding plug of the additional telecommunication set, a uniform connecting pattern for at least several applications being provided by a number of locating holes (39, 40, 41), characterized in that the printed circuit board (31) carries the fixed connecting terminals (36) and possesses a uniform connecting pattern with locating holes (39, 40, 41) for plug receptacles (43) formed by plug-in sockets (42) which can be inserted as required, said exchangeable and/or retrofitting plug-in sockets (42) being fixed on the circuit board (31) only with soldering connections (45) extending from their contacts (44), these soldering connections being designed to be inserted and soldered into the locating holes (39, 40, 41).

2. A connecting box according to Claim 1, characterized in that the circuit board (31) is inserted into, and fixed in, the base unit (24), said base unit consisting of a housing bottom section (28) and a housing top section (27) that can be attached to the former.

3. A connecting box according to Claims 1 or 2, characterized in that the fixed connecting terminals (36) are attached to the circuit board (31) by a strip member (37) and extend beyond the housing top section (27) of the housing-shaped base unit (24) through a cutout (38), said terminals resting on the planar housing lower section (28).

4. A connecting box according to Claims 1, 2 or 3, characterized in that the housing top section (27) is equipped with a series of duct-type projections (48) originating inside the unit, said projections providing a form-fit seat for the plug receptacles (43) which are of nearly U-shaped cross section and take the form of plug-in sockets (42).

5. A connecting box according to any of Claims 1 to 4, characterized in that the duct-type projections (48) provided in the housing top section (27), originating inside the unit and designed to afford a form-fit seat to plug receptacles (43) in the form of plug-in sockets (42), have bottoms (49) with cutouts (50) matching the corresponding plug profile.

6. A connecting box according to Claim 5, characterized in that the cutouts (50) matching the individual plug profiles and located in the bottoms (49) of the duct-type moldings (48) for the plug-in sockets (42) are closed with removable wall elements.

7. A connecting box according to any of Claims 1 to 6, characterized in that the cover (23) to be attached to the housing-shaped base unit (24) is equipped with female guide moldings (51) affording a form-fit seat to the plugs (20, 21, 22), said guide moldings taking the form of tube-shaped extensions (52) directed towards the housing-shaped base unit (24) and partially overlapping with the extension (53) projecting from the housing top section (27) which forms the duct-type receptacle (48) for the plug-in sockets (42).

8. A connecting box according to any of Claims 1 to 8, characterized in that the extension (53) projecting from the housing top section (29) and forming the duct-type receptacles (48) for the plug-in sockets (42) is equipped with extensions (54) which interlock with the female guide moldings (51) of the cover (23), said extensions each carrying a notching recess (55) for the notches (56) on the plugs (20, 21, 22).

9. A connecting box according to any of Claims 1 to 8, characterized in that the housing-shaped base unit (24) is equipped with a lateral surface (57), preferably on the side facing away from the terminals (36), said surface being intended for mounting of additional components such as line terminating devices, line attenuators or similar.

10. A connecting box according to Claim 9, characterized in that the housing upper section (27) is equipped with a cutout (58) to lead through connecting wires from additional components to the circuit board (31) mounted in the housing-shaped base unit (24).

**Revendications**

1. Boîte de raccordement pour le raccordement d'un téléphone et/ou d'un ou de plusieurs appareils additionnels tels qu'émetteur de numéros, haut-parleur, répondeur téléphonique, télécopieur, modem ou autres, constituée d'un élément de base en forme de boîter (24) qui porte un couvercle (23), et qui présente d'une part des bornes de raccordement fixes (36), par exemple des bornes à vis ou des bornes électriques qu'il n'est pas nécessaire de dénuder, pour la ligne de communication, et d'autre part au moins une fiche femelle (43) reliée aux bornes de raccordement (36) par l'intermédiaire de la plaque conductrice (31), pour la fiche mâle correspondante du téléphone et/ou des appareils additionnels, selon un modèle de raccordement standard, avec des perforations de réception (39, 40, 41) permettant au moins plusieurs utilisations, caractérisée par le fait que la plaque conductrice (31) porte les bornes de raccordement (36) et présente le modèle de raccordement standard avec les perforations (39, 40, 41) pour les fiches femelles (43) constituées par des socles embrochables (42) et à insérer selon les besoins; les socles (42) échangeables et/ou transformables sont fixés sur la plaque conductrice (31) simplement en étant insérés et soudés dans les perforations (39, 40, 41), au moyen de connexions soudées (45) qui partent de leurs contacts (44).

2. Boîte de raccordement selon la spécification 1, caractérisée par le fait que la plaque conductrice (31) est insérée et maintenue dans un élément de base (24) composé d'une partie inférieure de boîtier (28) à laquelle est fixée une partie supérieure de boîtier (27).

3. Boîte de raccordement selon les spécifications 1 ou 2, caractérisée par le fait que les bornes fixes (36) sont assujetties à la plaque conductrice (31) au moyen d'une baguette (37) et dépassent de la partie supérieure du boîtier (27) par une percée (38), tout en étant soutenues par la partie inférieure en forme de plaque du boîtier (28).

4. Boîte de raccordement selon les spécifications 1 à 3, caractérisée par le fait que la partie supérieure du boîtier (27) est dotée d'une série de logements en forme de gaine (48), partant de l'intérieur, en vue de l'encastrement des fiches femelles (43) constituées par des socles (42) et qui présentent une section approximativement en forme de U.

5. Boîte de raccordement selon les spécifications 1 à 4, caractérisée par le fait que les logements en forme de gaine (48), partant de l'intérieur et prévus dans la partie supérieure du boîtier (27) pour l'encastrement des fiches femelles (43) constituées par des socles (42), présentent dans leurs fonds (49) des percées (50) qui correspondent au profil respectif des fiches mâles.

6. Boîte de raccordement selon la spécification 5, caractérisée par le fait que les percées (50) correspondant au profil respectif des fiches mâles et ménagées dans les fonds (49) des logements (48) de socles (42), sont fermées par des cloisons amovibles.

7. Boîte de raccordement selon les spécifications 1 à 6, caractérisée par le fait que le couvercle (23) à fixer sur l'élément de base (24) comporte des gaines de guidage (51) dans lesquelles s'encastrent les fiches mâles (20, 21, 22). L'embout (53) de la partie supérieure du boîtier (27), qui constitue les logements en forme de gaine (48) pour les socles (42), s'emboîte partiellement dans le couvercle (23) constitué par un préformé tubulaire (52) dirigé vers l'élément de base en forme de boîtier (24).

8. Boîte de raccordement selon les spécifications 1 à 7, caractérisée par le fait que l'embout (53) de la partie supérieure du boîtier (27), qui constitue les logements en forme de gaine (48) pour les socles (42), présente des prolongements (54) qui s'insèrent dans les évidements latéraux des gaines de guidage (51) du couvercle (23), et qui sont dotés d'une encoche d'encliquetage (55) pour chaque saillie d'encliquetage (56) prévue sur les fiches mâles (20, 21, 22).

9. Boîte de raccordement selon les spécifications 1 à 8, caractérisée par le fait que l'élément de base en forme de boîtier (24) présente de préférence, au revers de la face des bornes (36) un rebord (57) destiné à la fixation d'éléments additionnels tels que des terminaisons et des amortisseurs de conduits ou autres.

10. Boîte de raccordement selon la spécification 9, caractérisée par le fait que la partie supérieure du boîtier (27) présente une percée (58) pour le passage des conduits de jonction qui vont des éléments additionnels à la plaque conductrice (31) installée dans l'élément de base en forme de boîtier (24).

FIG.1

FIG.2

*FIG.3*

*FIG.4*

FIG.5

FIG.6

FIG.7

FIG.8

FIG.9

FIG.10